(19) Europäisches Patentamt
European Patent Office
Office européen des brevets

(11) **EP 2 109 771 B1**

(12) **EUROPEAN PATENT SPECIFICATION**

(45) Date of publication and mention
of the grant of the patent:
**16.06.2010 Bulletin 2010/24**

(51) Int Cl.:
***G01N 33/543*** (2006.01)   ***G01R 33/06*** (2006.01)

(21) Application number: **08702540.9**

(22) Date of filing: **28.01.2008**

(86) International application number:
**PCT/IB2008/050295**

(87) International publication number:
**WO 2008/093276 (07.08.2008 Gazette 2008/32)**

(54) **A MAGNETIC SENSOR DEVICE FOR AND A METHOD OF SENSING MAGNETIC PARTICLES**

MAGNETSENSORVORRICHTUNG UND VERFAHREN ZUR ERFASSUNG MAGNETISCHER TEILCHEN

DISPOSITIF DE DÉTECTEUR MAGNÉTIQUE ET PROCÉDÉ DE DÉTECTION DE PARTICULES MAGNÉTIQUES ASSOCIÉ

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **01.02.2007 EP 07101589**

(43) Date of publication of application:
**21.10.2009 Bulletin 2009/43**

(73) Proprietor: **Koninklijke Philips Electronics N.V.**
**5621 BA Eindhoven (NL)**

(72) Inventors:
• **VAN DEN HOMBERG, Johannes, A., T., M.**
**NL-5656 AE Eindhoven (NL)**
• **TOL, Jeroen, J., A.**
**NL-5656 AE Eindhoven (NL)**
• **DURIC, Haris**
**NL-5656 AE Eindhoven (NL)**

(74) Representative: **Kroeze, Johannes Antonius**
**Philips**
**Intellectual Property & Standards**
**P.O. Box 220**
**5600 AE Eindhoven (NL)**

(56) References cited:
**EP-A- 1 469 311**     **EP-A- 1 659 405**
**US-A1- 2001 052 769**     **US-B1- 6 355 491**

**Description**

FIELD OF THE INVENTION

The invention relates to a magnetic sensor device for sensing magnetic particles.

The invention further relates to a method of sensing magnetic particles.

BACKGROUND OF THE INVENTION

A biosensor may be a device for the detection of an analyte that combines a biological component with a physicochemical or physical detector component.

EP 1 469 311 A1 discloses a magnetic biosensor comprising an array of hall sensors that are distributed in a sensitive surface and adapted to detect a small number of magnetic molecules. To magnetize the molecules such that they can induce a signal in a hall sensor, a magnetic coil is disposed above the sensor surface. Furthermore, a second coil may be disposed below the sensor surface for attracting magnetic molecules towards this surface during times when no measurement is made.

Magnetic biosensors may use the Giant Magnetoresistance Effect (GMR) for detecting biological molecules being magnetic or being labeled with magnetic beads.

In the following, biosensors will be explained which may use the Giant Magnetoresistance Effect.

WO 2005/010542 discloses the detection or determination of the presence of magnetic particles using an integrated or on-chip magnetic sensor element. The device may be used for magnetic detection of binding of biological molecules on a micro-array or biochip. Particularly, WO 2005/010542 discloses a magnetic sensor device for determining the presence of at least one magnetic particle and comprises a magnetic sensor element on a substrate, a magnetic field generator for generating an AC magnetic field, a sensor circuit comprising the magnetic sensor element for sensing a magnetic property of the at least one magnetic particle which magnetic property is related to the AC magnetic field, wherein the magnetic field generator is integrated on the substrate and is arranged to operate at a frequency of 100 Hz or above.

US 2004/0033627 discloses detecting substances of interest by using magnetic beads and easily manufactured electrical circuits to detect chemicals and/or substances of interest.

WO 2006/042839 discloses a device for measuring a magnetic field by using a magnetoresistive sensor comprising at least one magnetoresistive sensor, a module for measuring the resistance of the magnetoresistive sensor, a generator module for generating an additional magnetic field in the space containing the magnetoresistive sensor, and a control unit firstly for selectively controlling the generator module to apply an additional magnetic field pulse possessing a first value with first polarity that is positive or negative and magnitude that is sufficient to saturate the magnetoresistive sensor, and secondly for selectively controlling measurement of the resistance of the magnetoresistive sensor by the module for measuring resistance.

WO 2006/059268 discloses a method for calibrating a transfer function of a magnetic sensor on a substrate in which sensor the presence of magnetizable objects can be detected by magnetizing the objects by a magnetic field delivered by a magnetic field generator and in which the transfer function is defined as the transfer from an electrical input signal for generating the magnet field, via magnetic stray field radiated by the objects when magnetized, to an electrical output signal delivered by the sensor, comprising the steps of putting sample fluid on the substrate, the sample fluid comprising magnetizable objects, attracting part of the magnetizable objects towards the sensor, activating the electrical input signal, thereby generating the magnet field, measuring the electrical output signal as a response to the electrical input signal, and calculating the transfer function from the electrical input and output signals.

However, sufficient accuracy of measurement results may still be problematic under undesired circumstances.

OBJECT AND SUMMARY OF THE INVENTION

It is an object of the invention to provide a robust sensor readout topology.

In order to achieve the object defined above, a magnetic sensor device for sensing magnetic particles and a method of sensing magnetic particles according to the independent claims are provided.

According to an exemplary embodiment of the invention, a magnetic sensor device for sensing magnetic particles is provided, the magnetic sensor device comprising a first magnetic field generator unit excitable (by an electric signal such as a current signal) for generating a first magnetic field, a sensing unit adapted for sensing a signal indicative of the presence of the magnetic particles in the first magnetic field, a second magnetic field generator unit adapted for generating a second magnetic field (which differs from the first magnetic field) affecting (selectively) the sensing unit, and a processing circuitry adapted for processing the signal to form a digitized signal and adapted for feeding back (via a feedback loop) the processed (digitized) signal to the second magnetic field generator unit (as an excitation signal for exciting the second magnetic field generator unit).

According to another exemplary embodiment of the invention, a method of sensing magnetic particles is provided, the method comprising exciting a first magnetic field generator unit for generating a first magnetic field, sensing, by a sensing unit, a signal indicative of the presence of the magnetic particles in the first magnetic field, generating, by a second magnetic field generator unit, a second magnetic field affecting the sensing unit, and processing the signal to form a digitized signal and feeding back the processed (digitized) signal to the second magnetic field generator unit.

In the context of this application, the term "sample" may particularly denote any solid, liquid or gaseous substance to be analysed, or a combination thereof. For instance, the substance may be a liquid or suspension, furthermore particularly a biological substance. Such a substance may comprise proteins, polypeptides, nucleic acids, lipids, carbohydrates or full cells, etc.

The "substrate(s)" may be made of any suitable material, like glass, plastics, or a semiconductor. The term "substrate" may be thus used to define generally the elements for layers that underlie and/or overlie a layer or portions of interest. Also, the "substrate" may be any other base on which a layer is formed, for example a glass or metal layer.

The term "magnetic particles" may denote any molecules having a magnetic portion, that is to say a paramagnetic, a ferromagnetic, or a ferrimagnetic portion. Such a magnetic portion may be inherent to a specific molecule or may be attached as a separate label or bead to a molecule, for instance to a biomolecule. The term magnetic particles may refer to actual magnetic particles or to magnetizable particles (which are magnetized under the influence of an externally applied magnetic field).

The term "sensing unit" may particularly denote a portion of a sensor device at which an actual sensor event occurs or is detected, for instance a modification of a physical parameter of the sensor portion due to a hybridization between particles in the sample and capture molecules attached to a surface of the sensor portion.

According to an exemplary embodiment of the invention, a magnetic biosensor may be provided which has an additional magnetic field generator unit selectively influencing the sensing unit while keeping the magnetic particles (for example super-paramagnetic beads) to be detected essentially uninfluenced (i.e. they are not influenced, or they are influenced but to a much lesser degree). A feedback loop may be provided from an output of a processing circuitry (which may include sigma delta conversion) to the additional magnetic field generator unit so as to couple back the processed signal for influencing the sensing unit in accordance with a present detection signal. A feedback loop of a sigma delta A/D converter may therefore be extended over the magnetic domain to be insensitive to sensor gain variations. Such a sensor device may be robust, appropriate for low power applications, insensitive to sensor gain variations and may provide a digital output signal in one step.

According to an exemplary embodiment of the invention, a magnetic biosensor may be provided which feeds back a digitized output signal. This implements a signal processing path going from an analog input to a digital output - while having a feedback loop to overcome or reduce sensor gain variations - in a single step. In contrast to two-step approaches overcoming or reducing the gain variations by having feedback, but still having an analog output and thus needing a separate A/D converter to digitize before further processing of the data in a microprocessor, embodiments of the invention may be more power efficient.

The topology according to an exemplary embodiment of the invention may merge the feedback loop and A/D conversion, which may reduce power consumption, but may also facilitate simple demodulation of the bead-induced signal inside the loop (for instance by implementing two choppers), which greatly enhances the performance of the sigma delta ADC loop because of the higher resulting oversampling ratio. Further, crosstalk from the magnetic excitation field towards the magnetic sensing unit may be suppressed by a simple gating circuitry inside the loop. The term "gating" may particularly imply a repeated temporary disconnection of the input signal during the time intervals at which the crosstalk is strongest, to substantially disregard the resulting erroneous signal values.

Next, further exemplary embodiments of the magnetic sensor device .will be explained. However, these embodiments also apply to the method of sensing magnetic particles.

The magnetic sensor device may comprise a current modulator adapted for exciting the first magnetic field generator unit. Such a current modulator may apply an alternating excitation signal (AC) to the first magnetic field generator unit such as a first metallization wire. This AC excitation signal may be simply generated by means of a chopper that is adapted to convert a DC (reference) signal into the alternating signal.

The magnetic sensor device may comprise a sigma delta analog to digital converter, wherein the processing circuitry is part of the sigma delta analog to digital converter. Implementing a sigma delta ADC to convert the analog signal at a magnetic sensing unit, a feedback loop may be extended over a magnetic domain by having a DAC drive a specific reference wire instead of coupling it directly to the input of a loop filter in the electrical domain. This may suppress or substantially eliminate the effects of sensor gain variations.

The processing circuitry may comprise an analog-to-digital converter unit adapted for converting the analog signal received from the sensing unit into a digital signal. The processing circuitry may further comprise a digital to analog converter adapted for converting the digital signal into an analog feedback signal to be fed back to the second magnetic field generator unit. The processing unit may, moreover, comprise a loop filter, particularly an integrating loop filter, connected between the sensing unit and the analog to digital converter unit. By this architecture, an output signal of a magnetic biosensor is coupled back to a feedback wire which allows to eliminate undesired GMR sensitivity variations. Furthermore, crosstalk may be suppressed or eliminated by implementing gating.

The second magnetic field generator unit may be arranged for maintaining the magnetic particles essentially uninfluenced. By simultaneously significantly modifying the characteristic of the sensing unit, artefacts resulting from sensitivity variations may be reduced.

The processing circuitry may comprise a first chopper connected between the sensing unit and the loop filter. A second chopper may be connected between the analog to digital converter and the digital to analog converter. By such a chopper architecture, a synchronous operation of a plurality of mixers may be obtained so as to improve the operation of the sigma delta loop.

The magnetic sensor device may be adapted for sensing magnetic beads attached to biological molecules. Such biological molecules may be proteins, DNA, genes, nucleic acids, polypeptides, hormones, antibodies, etc.

Therefore, the magnetic sensor device may be adapted as a magnetic biosensor device, that is to say as a biosensor device operating on a magnetic detection principle.

At least a part of the magnetic sensor device may be realized as a monolithically Integrated Circuit (IC). Therefore, components of the magnetic sensor device may be monolithically integrated in a substrate, for instance a semiconductor substrate, particularly a silicon substrate. However, other semiconductor substrates are possible, like germanium, or any group III-group V semiconductor (like gallium arsenide or the like).

The magnetic sensor device may be adapted for sensing the magnetic particles based on an effect of the group consisting of GMR, AMR, and TMR, Hall etc. Examples for biosensors making use of the Giant Magnetoresistance Effect (GMR) are disclosed in WO 2005/010542 or WO 2005/010543. Thus, the sensor can be any suitable sensor based on the detection of magnetic properties of particles on or near to a sensor surface, for instance a coil, a wire, magneto-resistive sensor, magneto-strictive sensor, Hall sensor, planar Hall sensor, flux gate sensor, SQUID, magnetic resonance sensor, etc.

The device and method can be used with several biochemical assay types, for instance binding/unbinding assay, sandwich assay, competition assay, displacement assay, enzymatic assay, etc.

In addition to molecular assays, also larger moieties can be detected, for instance cells, viruses, or fractions of cells or viruses, tissue extract, etc.

The device, methods and systems according to embodiments of the invention are suited for sensor multiplexing (i.e. the parallel use of different sensors and sensor surfaces), label multiplexing (i.e. the parallel use of different types of labels) and chamber multiplexing (i.e. the parallel use of different reaction chambers).

The device, methods and systems described herein can be used as rapid, robust, and easy to use point-of-care biosensors for small sample volumes. The reaction chamber can be a disposable item to be used with a compact reader. Also, the device, methods and systems according to embodiments of the present invention can be used in automated high-throughput testing. In this case, the reaction chamber is for instance a well plate or cuvette, fitting into an automated instrument.

The aspects defined above and further aspects of the invention are apparent from the examples of embodiment to be described hereinafter and are explained with reference to these examples of embodiment.

BRIEF DESCRIPTION OF THE DRAWINGS

The invention will be described in more detail hereinafter with reference to examples of embodiment but to which the invention is not limited.

Fig. 1 illustrates a magnetic sensor device according to an exemplary embodiment.
Fig. 2 illustrates the principle of a GMR based magnetic biosensor comprising capture molecules.
Fig. 3 is a diagram illustrating a correlation between a resistance change and an external magnetic field of a biosensor.
Fig. 4 shows a circuit diagram illustrating operation of a magnetic biosensor.
Fig. 5 illustrates a diagram showing a proper operation point of a magnetic biosensor.
Fig. 6 shows a circuit diagram illustrating operation of a magnetic biosensor.
Fig. 7 illustrates a diagram showing a proper operation point of a magnetic biosensor.
Fig. 8 illustrates a sigma delta ADC architecture.
Fig. 9, Fig. 10, Fig. 12 to Fig. 14 illustrate magnetic sensor devices according to exemplary embodiments of the invention.
Fig. 11 illustrates a diagram showing crosstalk and bead signal influences of a detection signal.

DESCRIPTION OF EMBODIMENTS

The illustration in the drawing is schematically. In different drawings, similar or identical elements are provided with the same reference signs.

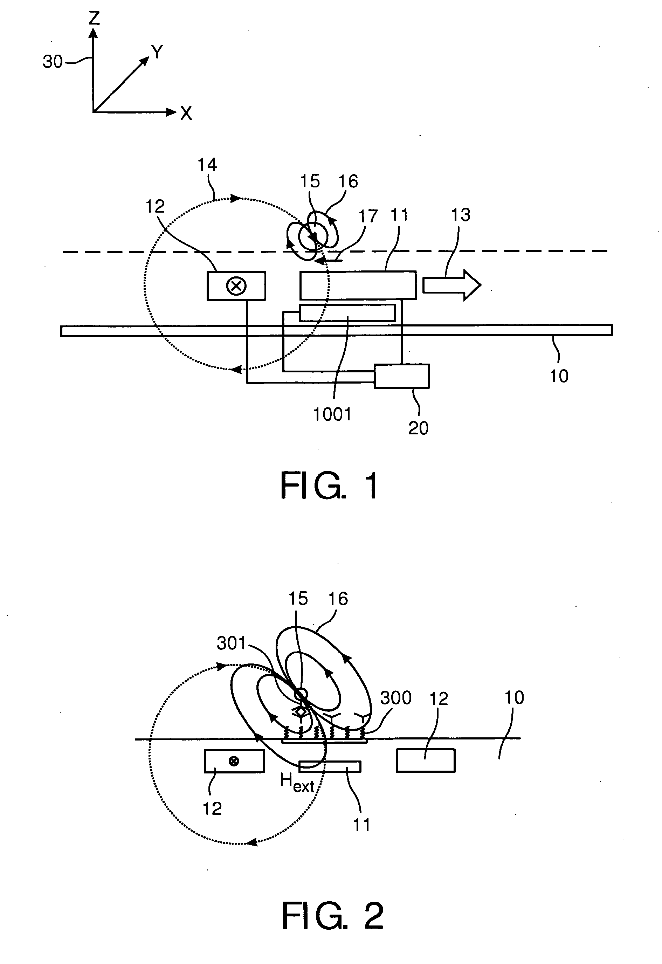

In a first embodiment the device according to the present invention is a biosensor and will be described with respect to Fig. 1. The biosensor detects magnetic particles in a sample such as a fluid, a liquid, a gas, a visco-elastic medium, a gel or a tissue sample. The magnetic particles can have small dimensions. With nanoparticles are meant particles having at least one dimension ranging between 0.1 nm and 1000 nm. The magnetic particles can acquire a magnetic moment due to an applied magnetic field.

The device may comprise a substrate 10 and a circuit e. g. an integrated circuit.

A measurement surface of the device is represented by the dotted line in Fig. 1. The circuit may comprise a magneto-resistive sensor 11 as a sensor element and a first magnetic field generator in the form of a conductor 12. The terms sensor unit 11, sensor, and sensor device are used as synonyms in the following. The sensor unit 11 can be any suitable sensor unit 11 based on the detection of the magnetic properties of particles to be measured on or near to the sensor surface. Therefore, the magnetic sensor unit 11 is designable as a coil, magneto-resistive sensor, magneto-restrictive sensor, Hall sensor, planar Hall sensor, flux gate sensor, SQUID (Semiconductor Superconducting Quantum Interference Device), magnetic resonance sensor, or as another sensor actuated by a magnetic field. The magneto-resistive sensor unit 11 may, for example, be a GMR, AMR, or a TMR type sensor. The magneto-resistive sensor unit 11 may for example have an elongated, for instance a long and narrow stripe geometry but is not limited to this geometry. Sensor 11 and conductor 12 may be positioned adjacent to each other with a second magnetic field generator in the form of a conductor 1001.

In Fig. 1, the feedback wire 1001 is drawn below the GMR element 11. The feedback wire 1001 may particularly be positioned on top of the GMR 1001 or below the GMR 1001 to generate a strong in-plane magnetic component. Also a combination of a top feedback wire and a bottom feedback wire can be applied.

In Fig. 1, a coordinate system is introduced to indicate that if the sensor device is positioned in the xy plane, the sensor 11 mainly detects the x-component of a magnetic field, i. e. the x-direction is the sensitive direction of the sensor 11. The arrow 13 in Fig. 1 indicates the sensitive x-direction of the magneto-resistive sensor 11 according to the present invention. Because the sensor 11 is hardly sensitive in a direction perpendicular to the plane of the sensor device, in the drawing the vertical direction or z-direction, a magnetic field 14, caused by a current flowing through the conductor 12, is not (or hardly) detected by the sensor 11 in absence of magnetic nano-particles 15.

When a magnetic material (this can for instance be a magnetic ion, molecule, nano-particle 15, a solid material or a fluid with magnetic components) is in the neighborhood of the conductor 12, it develops a magnetic moment whose presence is indicated by the field lines 16 in Fig. 1. This magnetic moment then generates dipolar stray fields, which have in-plane magnetic field components 17 at the location of the sensor 11. Thus, the nano-particle 15 deflects the magnetic field 14 into the sensitive x-direction of the sensor 11 indicated by arrow 13. The x-component of the magnetic field Hx which is in the sensitive x-direction of sensor 11, is sensed by the sensor 11 and depends on the number of magnetic nano-particles 15 and the conductor current Ic.

For further details of the general structure of similar sensors, reference is made to WO 2005/010542 and WO 2005/010543.

Reference numeral 20 in Fig. 1 illustrates a control unit coordinating the operation mode of the sensing unit 11 and of the magnetic field generator 12 and coupling a processed digital output signal back as an input signal of the second magnetic field generator 1001.

Next, some general aspects on the detection of magnetic particles will be explained which may serve for a proper understanding of embodiments of the invention.

Magneto-resistive biochips have interesting properties for bio-molecular diagnostics, in terms of sensitivity, specificity, integration, ease of use, and costs. A cross-sectional view of such a biosensor with integrated excitation is depicted in Fig. 2.

This biosensor is based on a hybridisation between capture molecules 300 immobilized on a sensor surface and complementary biomolecules 301 having attached thereto a label of magnetic beads 15.

A current flowing in the wire 12 generates a magnetic field, which magnetizes one or more super paramagnetic beads 15. The stray field from the super-paramagnetic bead 15 introduces an in-plane magnetization component $H_{ext}$ in the GMR sensor unit 11, which results in a resistance change $\Delta R_{GMR}(H_{ext})$.

This resistance change is then measured to determine the amount of beads 15 present near the sensor surface.

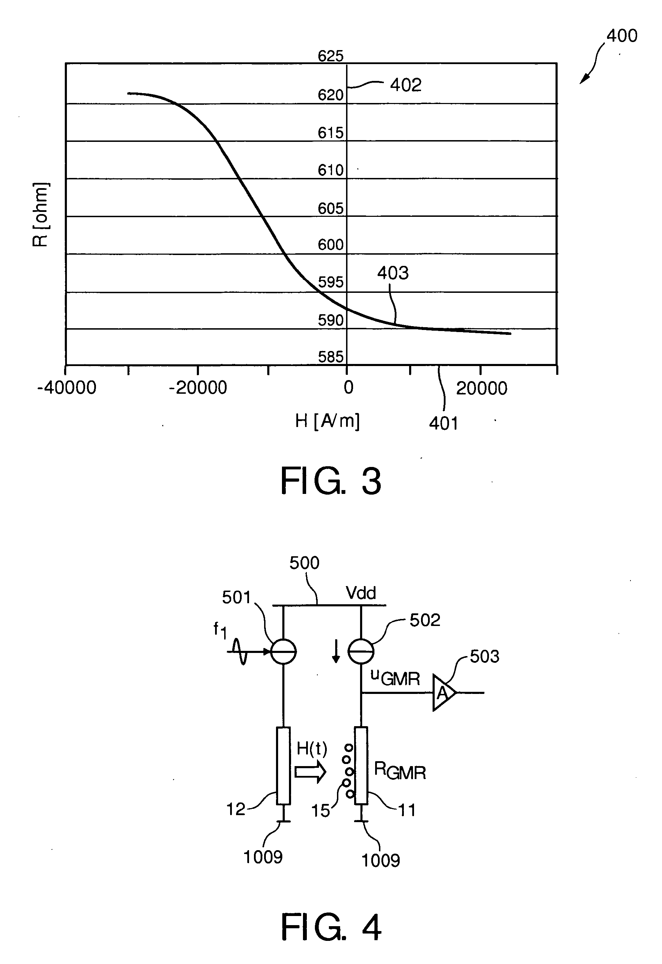

Fig. 3 shows a diagram 400 illustrating a curve 403 as an example of the GMR resistance (plotted along an ordinate 402 of the diagram 400) as a function of the magnetic field $H_{ext}$ in the sensitive plane of the GMR stack (plotted along an abscissa 401 of the diagram 400).

The GMR sensitivity $s_{GMR} = \dfrac{dR_{GMR}}{dH_{ext}}$ is not constant but may depend on $H_{ext}$.

As the induced magnetic field $H_{ext}$ by the beads 15 is very low, only small resistance changes will occur in the GMR 11. Moreover, the GMR 11 generates a substantial amount of low frequency 1/f noise, which is of magnetic origin. To allow the signal-to-noise ratio to be determined by the thermal noise floor of the sensor element 11 alone, the excitation current in the wires 12 is generally up-modulated in the frequency spectrum, above the 1/f noise corner frequency $f_c$ of the GMR 11.

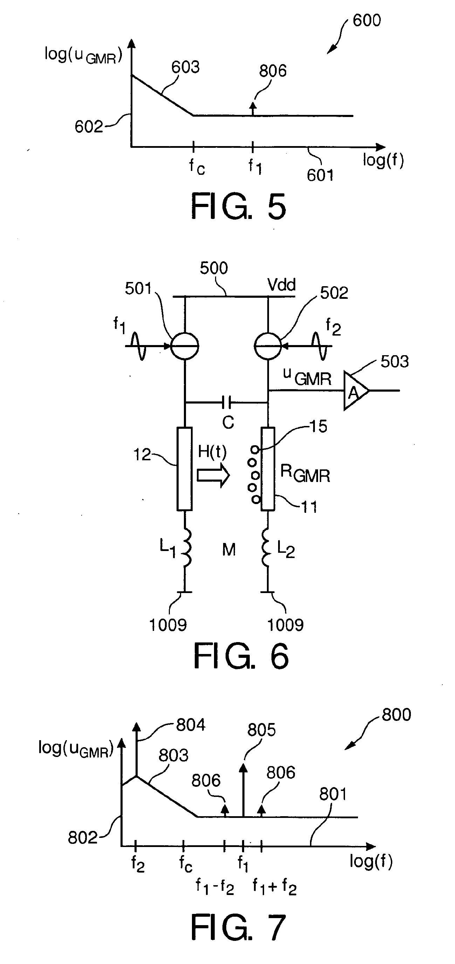

This is illustrated in a Fig. 4 and in a diagram 600 shown in Fig. 5.

Fig. 4 shows a circuitry of a magnetic sensor device and additionally illustrates an upper electric potential 500 and a lower electric potential 1009. An excitation current source 501, a sense current source 502, and an amplifier 503 are shown as well.

The diagram 600 comprises an abscissa 601 along which the frequency is plotted and comprises an ordinate 602 along which a sense signal is plotted, see curve 603.

Due to capacitive and inductive coupling between the current wires 12, the lead wires (connections, flex) and the GMR sensor 11, a strong cross talk signal at the bead excitation frequency $f_1$ appears at the output of the amplifier 503. This signal coincides with the magnetic signal from the beads 15.

The phase and the amplitude of the crosstalk signal depend heavily on the circuit layout and the values of the distributed resistances and capacitances and inductive coupling. Mostly, the cross talk phase appears to be between 60 and 120 degrees.

There are two conventional approaches to deal with this crosstalk signal:

The first conventional approach relies on synchronism, where the crosstalk signal is cancelled by a second signal with the proper amplitude and phase, or alternatively the detection of the wanted signal is done at the exact zero crossings of the crosstalk signal.

The second conventional approach is to modulate the current through the GMR at a second frequency $f_2$, and make use of the fact that the GMR effectively acts as a mixer by multiplying the magnetic signal at $f_1$ by the sense current at $f_2$. In this way, the electrical crosstalk and the desired magnetic signal are separated in the frequency domain, see Fig. 6 and in a diagram 800 shown in Fig. 7.

The diagram 800 comprises an abscissa 801 along which the frequency is plotted and comprises an ordinate 802 along which a sense signal is plotted, see curve 803. A frequency of the sense current 804, a frequency of cross talk 805, and a magnetic frequency 806 are plotted as well.

After filtering, amplification and demodulation (for instance amplitude detection) of the wanted magnetic signal, generally an analog to digital conversion procedure is required to facilitate post-processing of the measured signal in the digital domain.

However, the sensitivity of the GMR may still vary due to external factors such as

- Externally applied magnetic fields,
- Temperature variations,
- Light exposure variations,
- Processing spread and
- Aging.

This limits the achievable accuracy of the sensor and thereby the estimation of the number of beads 15 present at the GMR 11 surface. Furthermore, internal compensation techniques for magnetic and capacitive crosstalk can fail when the GMR sensitivity varies.

The electrical crosstalk signal at the GMR 11 is typically 10,000 times larger than the wanted signal from the beads 15, which makes synchronous cancellation or detection very difficult. Even the smallest phase shift between the cancellation or detection signal and the crosstalk signal will lead to improper suppression of the crosstalk. The exact phase of the crosstalk signal is dependent on the physical layout of the sensor and the values of the formed inductors, capacitors and resistors. This implies that it is dependent on external parameters like temperature, light exposure and presence of other (electrically or magnetically conductive) objects, which makes it very difficult to predict the exact phase of the crosstalk signal. In practice, this implies that one will have to rely on relatively complex auto-calibrating loops.

In case of a dual frequency ($f_1$-$f_2$) system, the GMR current is modulated at $f_2$ with an as large as possible amplitude to increase sensitivity. A low noise pre-amplifier is connected to the GMR 11 to detect the wanted signal at $f_1$-$f_2$ and/or $f_1$+$f_2$. Without proper pre-filtering, the sensitive amplifier would easily be driven into saturation by the strong signal at $f_2$, thereby preventing correct measurement of the wanted signal. Such a pre-filter is difficult to integrate, because it requires large area for the coupling capacitances and a high bandwidth pre-amplifier A. The latter is because the sense-current interference at $f_2$ may be 1,000,000 times larger than the wanted magnetic signal at $f_1$-$f_2$ and/or $f_1$+$f_2$. In order to obtain sufficient suppression of the $f_2$ component with a simple (for instance first order) filter, large $f_1$ and $f_2$ frequency separation is required.

The application of this technology may be mobile (battery operated), which limits the total available energy budget. It is in general required to reduce or minimize the power consumption of the device in order to maximize battery lifetime. Therefore, it is desired to come to a digital representation of the analog input value (concentration of beads) in as little as possible procedures. A solution where amplification, detection and digitization is merged into a single, low power topology is preferred over a cascade of individual functions.

Next, exemplary embodiments of the invention will be explained.

Based on the above considerations, embodiments of the invention provide an uncomplicated and compact architecture, which is insensitive to GMR sensitivity variations and crosstalk, applies a single-frequency ($f_1$) measurement technique that avoids the need for pre-filtering and provides a digital output representation of the input signal at the same time.

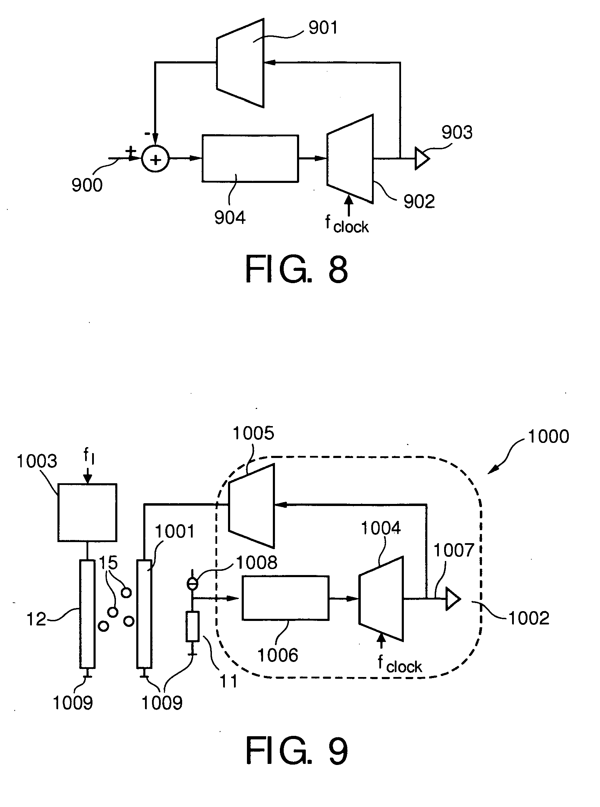

Embodiments of the invention are based on a Sigma Delta Analog to Digital Converter as shown in Fig. 8.

The basic operation is as follows: The analog input signal 900 is compared to a DAC 901 output signal, whose input is taken from the digital output 903 of the total converter. All differences (errors) are fed into a (usually integrating-) loop filter 904, which provides high gain in the band of interest for the analog input signal 900 and low gain at other frequencies. Consequently, the quantization noise and any nonlinearity of the quantizer (ADC) 902 is effectively suppressed within the band of interest while the energy associated with these errors is moved to out-of-band frequencies. This behavior is generally referred to as "noise shaping". Due to the high gain in the loop the in-band linearity and noise performance of a sigma delta converter is mainly determined by the linearity and noise of the feedback DAC 901, while being very tolerant to low performance of the quantizer 902. This is favorable, as a DAC 901 with good performance is much easier to construct than an ADC 902 with similar performance.

In the following, referring to Fig. 9, a magnetic sensor device 1000 according to an exemplary embodiment of the invention will be explained.

The magnetic sensor device 1000 for sensing magnetic particles 15 comprises a first magnetic field generator unit 12 excitable for generating a first magnetic field for excitation of the magnetic beads. Furthermore, a sensing unit 11 is provided which is adapted for sensing a signal indicative of the presence of the magnetic particles 15 in the first magnetic field. A second magnetic field generator unit 1001 is provided and adapted for generating a second magnetic field (affecting the sensing unit 11) for compensation of the bead-induced magnetic field. This compensation field should not (or only minimally) affect the beads 15. A processing circuitry 1002 is adapted for processing the signal and is adapted for feeding back the processed signal to the second magnetic field generator unit 1001. A current modulator 1003 is provided and adapted for exciting the first magnetic field generator unit 12.

The processing circuitry 1002 comprises a sigma delta analog to digital converter, as will be explained in the following in more detail.

The sigma delta converter comprises an analog to digital converter 1004 adapted for converting the analog signal into a digital signal. Furthermore, a digital to analog converter 1005 is provided and adapted for converting the digital signal into an analog feedback signal to be fed back to the second magnetic field generator 1001. An integrating loop filter 1006 is connected between the sensing unit 11 and the analog to digital converter 1004. The second magnetic field generator 1001 is arranged for maintaining the magnetic particles 15 essentially uninfluenced.

The wire 12 may also be denoted as an excitation wire, whereas the wire 1001 may also be denoted as a feedback wire.

At an output 1007 of the device 1000, a digital output signal is provided. A clock signal $f_{clock}$ operates the ADC 1004. Furthermore, a current source 1008 is provided for operating the sensing unit 11. The current modulator 1003 is fed with a signal $f_l$.

Furthermore, connections of the excitation wire 12 and of the feedback wire 1001 are brought to the electrical ground potential 1008.

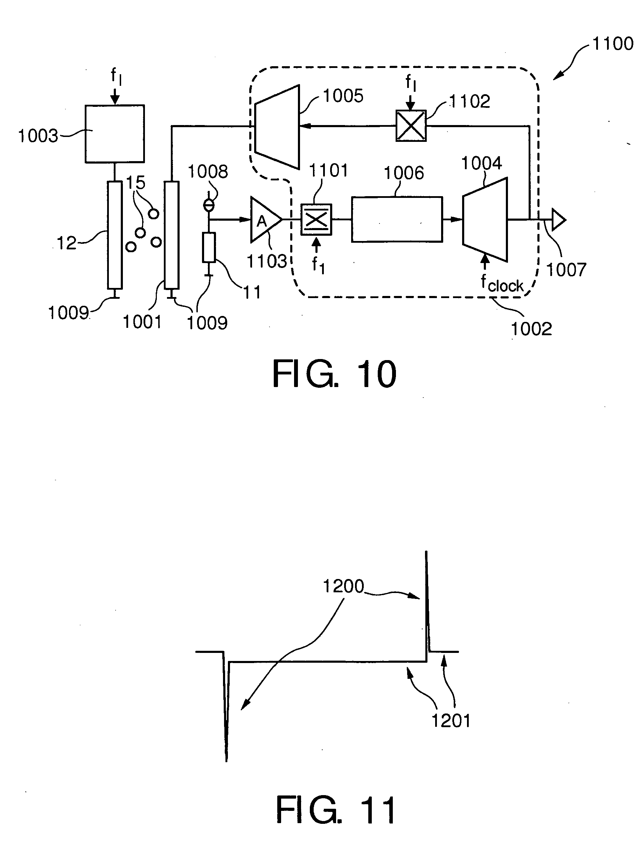

In the embodiment 1100 of Fig. 10, a first chopper 1101 1 is additionally connected between the sensing unit 11 and the loop filter 1006, and a second chopper 1102 is connected between the analog to digital converter 1004 and the digital to analog converter 1005. An amplifier 1103 is connected between the current source 1008 and the chopper 1101.

This feedback-wire 1001 (or reference-wire) should be placed in such a way that its magnetic field has a strong component directly in the sensitive plane of the GMR 11, while on the other side exciting the beads 15 as little as possible. The electrical output signal of the GMR 11 will represent the sum of the magnetic field from the feedback wire 12 and the magnetic field induced by the beads 15, and is fed to the input of loop filter H 1006. Due to the negative feedback in the converter, the average sum signal on the GMR 11 will be regulated towards zero. In other words, the magnetic feedback field has averagely cancelled the magnetic field from the beads 15.

A main advantage of this architecture is that an average magnetic field of zero means that the actual sensitivity (conversion gain) of the GMR 11 is substantially irrelevant. This solves the problems caused by temperature drift, processing tolerances etc. In the situation of a sigma delta converter, the word "average" may be emphasized because the DACs 1005 output is quantized instead of continuous, preventing exact cancelling at all times. However, as stated before, the noise shaping property of a sigma delta ADC ensures a good signal-to-noise ratio in the band of interest, which makes a two-step cascade of an analog zeroing feedback loop followed by an AD converter superfluous.

In a biosensor system, the modulation frequency $f_1$ for the excitation field is much higher than the bandwidth of interest, which is placed around $f_1$, and often only a few Hz wide. Although it is possible to let the sigma delta ADC convert the whole band from DC to $f_1$ and perform the filtering and demodulation in the digital domain, this is not the most economical solution. The sigma delta converter would require a relatively high clock-frequency to have sufficient oversampling (ratio between quantizer clock frequency and input bandwidth), and a digital filter running at high clock frequency consumes a substantial amount of power.

In Fig. 10, a chopper 1101 is placed in front of the (integrating) loop filter 1006. A chopper 1101 passes its input signal to its output unchanged or inverted, depending on its digital input value. If the chopper 1101 is driven by a clock signal at $f_1$ this causes mixing and shifts the band of interest around $f_1$ to around DC.

When the chopper 1101 is provided, another chopper 1102 is necessary in the feedback path to modulate the output signal around DC back up to around $f_1$ and close the loop. The chopper 1102 in the feedback path is preferably placed in the digital domain (before the DAC 1005) where it can simply be formed by logic gates.

The analog chopper 1101 in the forward path can be preceded by a pre-amplifier A 1103 to lower its input-referred distortion and noise contribution. When both mixers run synchronously, the behavior of the sigma delta loop itself is not influenced, but analog input signals around $f_1$ appear around DC in the digital output spectrum of the converter, and DC input signals appear around $f_1$ in the digital output spectrum.

An advantage of this architecture is that demodulation and digitization is performed in one procedure. In other words, the digital output signal is a direct measure for the amplitude of the magnetic field at $f_1$ induced by the beads 15. Any noise and spurious signals outside the bandwidth of interest can now be removed by a simple low pass filter in the digital domain. Moreover, when compared to a conventional sigma delta converter, this architecture has a significantly higher effective oversampling ratio because the band of interest at its output now is only from DC to a few Hz. This allows a much lower clock frequency for the same performance, which leads to a considerable reduction in power.

Thus, according to an exemplary embodiment of the invention, a conventional sigma delta structure may be modified with two choppers to get much better performance to power ratio. This may allow to perform demodulation of the bead signal in the same step.

When the excitation field is modulated as a square wave, it is very simple to make use of the differences in bandwidth of the crosstalk and the induced bead signal. Although the crosstalk has a very strong signal component at $f_1$, the low impedance of the GMR 11 and the relatively small capacitances and inductances that cause the crosstalk form a high-pass filter with high corner-frequency. When the signal at the GMR 11 is observed in the time-domain the crosstalk emerges as a very large, but short needle at each transition in the (small) bead induced signal, see Fig. 11 illustrating cross talk 1200 and a bead signal 1201.

A temporary disconnection of the signal can be made for a short time period around the occurrence of each crosstalk spike, to effectively disregard the erroneous (saturated) output of the pre-amplifier during the spike. The periodic temporary disconnection can be realized by a simple modification in the chopper 1101 between pre-amplifier 1103 and loop filter 1006, or by separate switches in series with this chopper 1101. Since the loop filter 1006 in the above described sigma delta converter is of integrating nature, it will hold its last value when its input is temporarily disconnected. Therefore the operation of the sigma delta converter is not disturbed as long as the disconnection is short in comparison to the clock period. If the pre-amplifier 1103 is designed to recover from the overload situation within the temporarily disconnected period (from here on called blanking period), no frequency domain filtering between GMR 11 and pre-amplifier 1103 is required. This is very beneficial for an implementation in an Integrated Circuit (IC) where passive filters require large chip area. Further, blanking greatly relaxes the demands on synchronism between the excitation field, chopper 1101 and chopper 1102 in the system, as all can change state somewhere in the same blanking period. The effect of all these individual state changes will become perceptible to the loop filter 1006 at exactly the same time, being the end of blanking period.

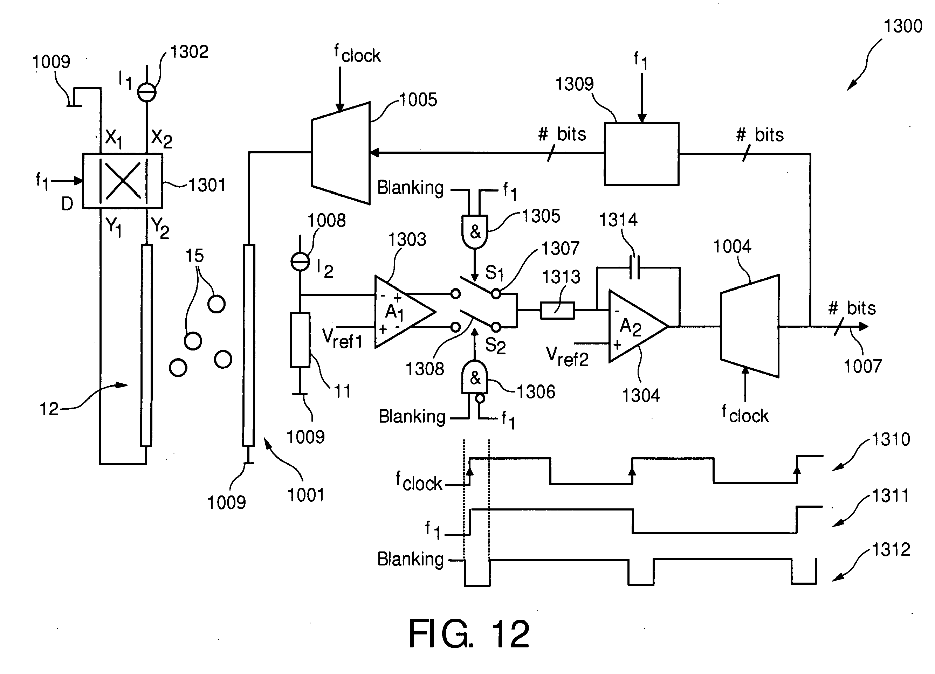

In the following, referring to Fig. 12, a magnetic sensor device 1300 according to an exemplary embodiment of the invention will be explained. The embodiment of Fig. 12 involves a first order loop filter with multibit quantizer and DAC.

The magnetic sensor device 1300 comprises a chopper 1301 as well as a DC current source 1302 realizing the unit 1003 of Fig. 9. A first amplifier 1303 and a second amplifier 1304 are provided. Outputs of AND gates 1305, 1306 operate switches 1307, 1308.

Furthermore, a digital data inverter unit 1309 is provided. A clock signal 1310, an operation signal 1311 for operating the chopper 1301 and a blanking signal 1312 forming an input of the end gates 1305 are illustrated as well. Furthermore, a resistor 1313 and a capacitor 1314 are illustrated.

In Fig. 12, the modulating current for the excitation wire 12 is generated by means of a differential chopper 1301 and a DC current source 1302 $I_1$. The chopper 1301 is a common building block comprising four switches, that either connect X1 and X2 directly to Y1 and Y2, or cross-coupled (X1 to Y2 and X2 to Y1), depending on the digital input level at the Data input D. By driving the D input with a clock signal with frequency $f_1$, the magnetic excitation field is square wave modulated at $f_1$ with an amplitude determined by current source $I_1$ and the physical layout of the wire.

The signal at the GMR 11 is amplified by a differential amplifier 1303 A1 that provides an amplified signal in positive and negative phase. The second input of amplifier 1303 A1 is connected to an appropriate DC voltage, but can also be connected to a differential setup of the GMR 11. Switch S1 1307 is closed during the high phase of $f_1$ and switch S2 1308 is closed during the low phase to realize the chopping at $f_1$ in the forward path. Both drive signals for switches 1307 S1 and 1308 S2 are fed through a logic gate that ANDs them with the blanking signal, see units 1305, 1306. This achieves a temporarily disconnection of the loop filter during the crosstalk spikes. The loop filter itself is a common integrator built around amplifier 1304 $A_2$. Its output signal is quantized by the ADC 1004 which runs at $f_{clock}$. In this example $f_{clock}$ is $2f_1$, but it can be any other multiple if desired.

As the DAC 1005 in the feedback path is also clocked at $f_{clock}$, crosstalk spikes will occur at the GMR 11 at $f_{clock}$. Additional crosstalk spikes are present at $f_1$ (caused by the excitation wire 12), so it is preferable to have an integer number as ratio between $f_{clock}$ and $f_1$. This way, the blanking signal can be directly derived from $f_{clock}$ and block all crosstalk spikes simultaneously. The chopper in the feedback path is a simple digital block that passes the digital value unchanged or inverted, depending on the state of $f_1$. Further, the number of bits for the quantizer 1004 and DAC 1005 can be chosen freely, depending on the required accuracy and dynamic range.

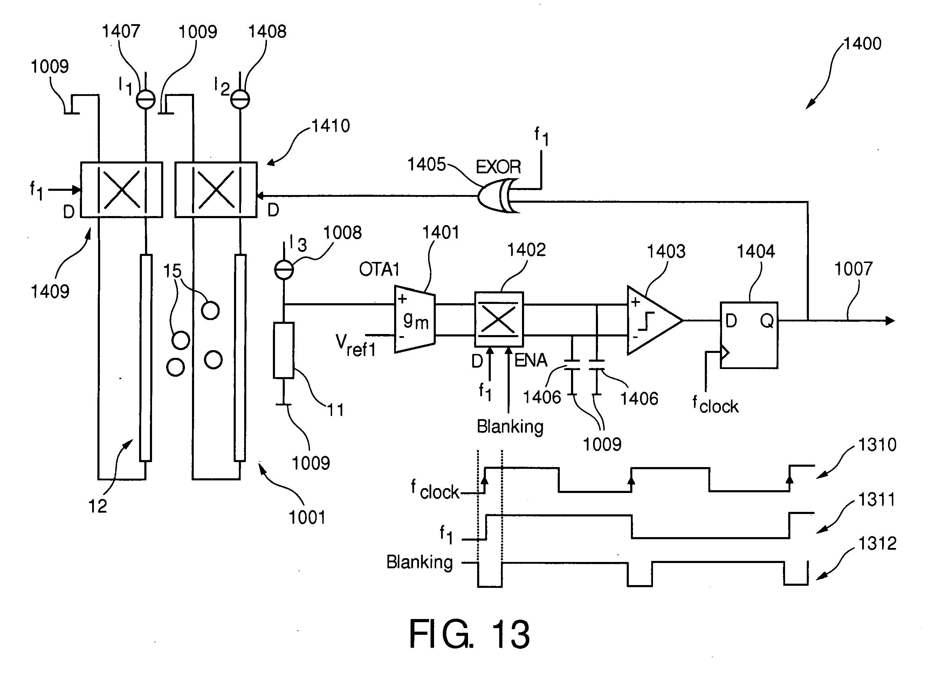

In the following, referring to Fig. 13, a magnetic sensor device 1400 according to an exemplary embodiment of the invention will be explained. This embodiment implements a first order loop filter with one bit quantizer and DAC.

In the embodiment of Fig. 13, the processing circuitry comprises an integrator 1401, a chopper 1402, a comparator 1403, a flip-flop 1404 and an XOR gate 1405. Beyond this, capacitors 1406 are connected. First and second exciting current sources 1407, 1408 for driving choppers 1409, 1410 are provided.

In realizations of the biosensor platform, the excitation frequency $f_1$ is around 500kHz to 1MHz. Consequently, the sigma delta converter is clocked at at least 1MHz to 2MHz. Because of the very narrow band of interest this gives a very high oversampling ratio. This means that the quantization noise in the band of interest is suppressed sufficiently to allow to lower the number of bits in the ADC 1004 and DAC 1005 to one, while maintaining good noise performance. The feedback DAC 1005 can now be implemented as a simple chopper 1410, the digital data inverter is a logic XOR gate 1405 and the quantizer is only a single comparator 1403 and a flipflop 1404.

The differential preamplifier 1303 is replaced by a differential OTA1 (operational transconductance amplifier) 1401 which has differential current outputs. This way the integrator function can be formed by simple capacitors 1406 to ground. Moreover, the pre-amplifier function to reduce the input-referred noise and distortion of the chopper is combined with the amplifier for the integrator stage in the sigma delta converter, thus saving power.

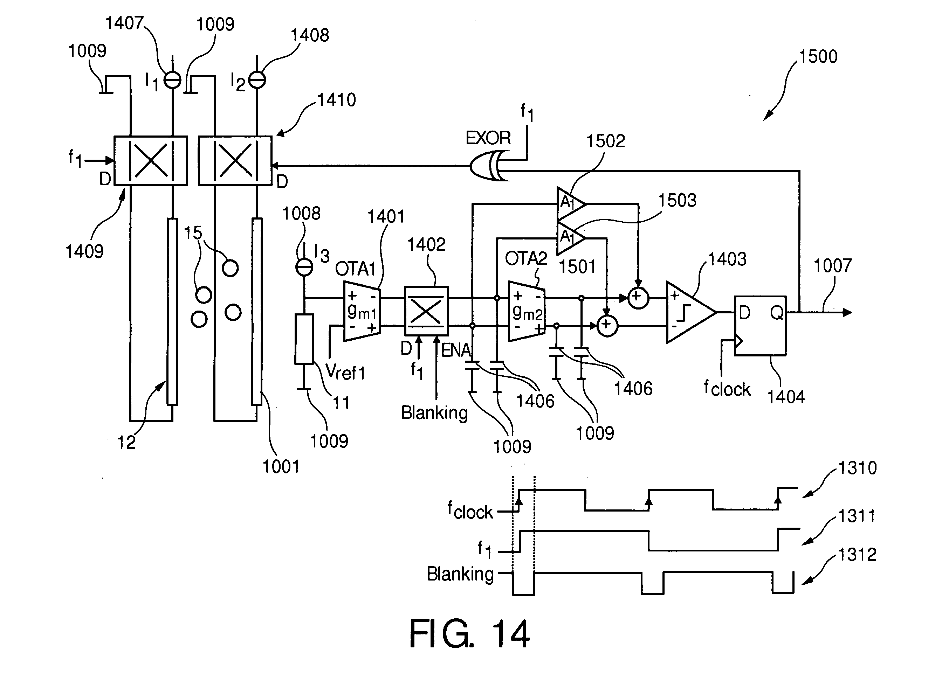

In the following, referring to Fig. 14, a magnetic biosensor device 1500 according to an exemplary embodiment of the invention will be explained. This embodiment includes a higher order loop filter with one bit quantizer and DAC.

In addition to Fig. 13, an additional integrator unit 1501 is provided. Beyond this, amplifiers 1502, 1503 are provided.

By adding integrators in cascade the order of the loop filter can be increased to provide higher gain in the band of interest and thereby further improve the dynamic range, just as for any conventional sigma delta converter. To ensure stability of the feedback loop the filter must show first order behavior around the unity gain frequency of the loop. Several solutions to decrease the order of the filter at higher frequencies are known. One approach is to make feedback paths from each integrator output towards the input of the converter, and another is to create feedforward paths from each integrator output towards the input of the quantizer. Both techniques can be used in this converter. Fig. 14 shows an example of a second order loop filter with feedforward coefficients $A_1$ to realize first order behavior around half the sample frequency.

Finally, all described embodiments show a time-continuous loop filter, but a switched-capacitor implementation of one or all integrator stages can also be performed.

It should be noted that the term "comprising" does not exclude other elements or features and the "a" or "an" does not exclude a plurality. Also elements described in association with different embodiments may be combined.

It should also be noted that reference signs in the claims shall not be construed as limiting the scope of the claims.

**Claims**

1. A magnetic sensor device (1000) for sensing magnetic particles (15), the magnetic sensor device (1000) comprising

   a first magnetic field generator unit (12) excitable for generating a first magnetic field;
   a sensing unit (11) adapted for sensing a signal indicative of the presence of the magnetic particles (15) in the first magnetic field;
   a second magnetic field generator unit (1001) adapted for generating a second magnetic field affecting the sensing unit (11);
   a processing circuitry (1002) adapted for processing the signal to form a digitized signal and adapted for feeding back the processed signal to the second magnetic field generator unit (1001).

2. The magnetic sensor device (1000) of claim 1, comprising a current modulator (1003) adapted for exciting the first magnetic field generator unit (12).

3. The magnetic sensor device (1000) of claim 1, comprising a sigma delta analog to digital converter, wherein the processing circuitry (1002) is part of the sigma delta analog to digital converter.

4. The magnetic sensor device (1000) of claim 1, wherein the processing circuitry (1002) comprises an analog to digital converter (1004) adapted for converting the signal, being an analog signal, into a digital signal.

5. The magnetic sensor device (1000) of claim 4, wherein the processing circuitry (1002) comprises a digital to analog converter (1005) adapted for converting the digital signal into an analog feedback signal to be fed back to the second magnetic field generator unit (1001).

6. The magnetic sensor device (1000) of claim 4, wherein the processing circuitry (1002) comprises a loop filter (1006), particularly an integrating loop filter, connected between the sensing unit (11) and the analog to digital converter (1004).

7. The magnetic sensor device (1000) of claim 1, wherein the second magnetic field generator unit (1001) is arranged for maintaining the magnetic particles (15) essentially uninfluenced.

8. The magnetic sensor device (1100) of claim 6, wherein the processing circuitry (1002) comprises a first chopper (1101) connected between the sensing unit (11) and the loop filter (1006).

9. The magnetic sensor device (1000) of claim 5, wherein the processing circuitry (1002) comprises a second chopper (1102) connected between the analog to digital converter (1004) and the digital to analog converter (1005).

10. The magnetic sensor device (1000) of claim 1, wherein the sensing unit (11) is adapted for sensing the magnetic particles (15) based on the Giant Magnetoresistance Effect.

11. The magnetic sensor device (1000) of claim 1, wherein the sensing unit (11) is adapted for quantitatively sensing the magnetic particles (15).

12. The magnetic sensor device (1000) of claim 1, adapted for sensing magnetic beads attached to biological molecules.

13. The magnetic sensor device (1000) of claim 1, wherein at least a part of the magnetic sensor device (1000) is realized as a monolithically integrated circuit.

14. The magnetic sensor device (1000) of claim 1, wherein the processing circuitry (1002) is adapted for digitizing an analog signal and for feeding back the digitized signal.

15. A method of sensing magnetic particles (15), the method comprising

exciting a first magnetic field generator unit (12) for generating a first magnetic field;
sensing, by a sensing unit (11), a signal indicative of the presence of the magnetic particles (15) in the first magnetic field;
generating, by a second magnetic field generator unit (1001), a second magnetic field affecting the sensing unit (11);
processing the signal to form a digitized signal and feeding back the processed signal to the second magnetic field generator unit (1001).

**Patentansprüche**

1. Magnetsensorvorrichtung (1000) zur Erfassung magnetischer Teilchen (15),
wobei die Magnetsensorvorrichtung (1000) Folgendes umfasst:

eine erste Magnetfeld-Erzeugungseinheit (12), die anregbar ist, um ein erstes Magnetfeld zu erzeugen;
eine Erfassungseinheit (11), die vorgesehen ist, um ein Signal zu erfassen, das auf die Anwesenheit der magnetischen Teilchen (15) in dem ersten Magnetfeld hinweist;
eine zweite Magnetfeld-Erzeugungseinheit (1001), die vorgesehen ist, um ein zweites Magnetfeld zu erzeugen, das die Erfassungseinheit (11) beeinflusst;
eine Verarbeitungsschaltung (1002), die vorgesehen ist, um das Signal zu verarbeiten, um ein digitalisiertes Signal zu bilden, und die vorgesehen ist, um das verarbeitete Signal an die zweite Magnetfeld-Erzeugungseinheit (1001) zurückzuleiten.

2. Magnetsensorvorrichtung (1000) nach Anspruch 1, mit einem Strommodulator (1003), der vorgesehen ist, um die erste Magnetfeld-Erzeugungseinheit (12) anzuregen.

3. Magnetsensorvorrichtung (1000) nach Anspruch 1, mit einem Sigma-Delta-Analog-Digital-Umsetzer, wobei die Verarbeitungsschaltung (1002) Teil des Sigma-Delta-Analog-Digital-Umsetzers ist.

4. Magnetsensorvorrichtung (1000) nach Anspruch 1, wobei die Verarbeitungsschaltung (1002) einen Analog-Digital-Umsetzer (1004) umfasst, der vorgesehen ist, um das Signal, bei dem es sich um ein analoges Signal handelt, in ein digitales Signal umzusetzen.

5. Magnetsensorvorrichtung (1000) nach Anspruch 4, wobei die Verarbeitungsschaltung (1002) einen Digital-Analog-Umsetzer (1005) umfasst, der vorgesehen ist, um das digitale Signal in ein analoges Rückmeldesignal umzusetzen, das an die zweite Magnetfeld-Erzeugungseinheit (1001) zurückzuleiten ist.

6. Magnetsensorvorrichtung (1000) nach Anspruch 4, wobei die Verarbeitungsschaltung (1002) einen Schleifenfilter (1006) umfasst, insbesondere einen integrierenden Schleifenfilter, der zwischen die Erfassungseinheit (11) und den Analog-Digital-Umsetzer (1004) geschaltet ist.

7. Magnetsensorvorrichtung (1000) nach Anspruch 1, wobei die zweite Magnetfeld-Erzeugungseinheit (1001) vorgesehen ist, um die magnetischen Teilchen (15) im Wesentlichen unbeeinflusst halten.

8. Magnetsensorvorrichtung (1100) nach Anspruch 6, wobei die Verarbeitungsschaltung (1002) einen ersten Zerhacker (1101) umfasst, der zwischen die Erfassungseinheit (11) und den Schleifenfilter (1006) geschaltet ist.

**9.** Magnetsensorvorrichtung (1000) nach Anspruch 5, wobei die Verarbeitungsschaltung (1002) einen zweiten Zerhacker (1102) umfasst, der zwischen den Analog-Digital-Umsetzer (1004) und den Digital-Analog-Umsetzer (1005) geschaltet ist.

**10.** Magnetsensorvorrichtung (1000) nach Anspruch 1, wobei die Erfassungseinheit (11) vorgesehen ist, um die magnetischen Teilchen (15) basierend auf dem GMR-Effekt (Giant Magnetoresistance) zu erfassen.

**11.** Magnetsensorvorrichtung (1000) nach Anspruch 1, wobei die Erfassungseinheit (11) vorgesehen ist, um die magnetischen Teilchen (15) quantitativ zu erfassen.

**12.** Magnetsensorvorrichtung (1000) nach Anspruch 1, vorgesehen zum Erfassen von an biologischen Molekülen angebrachten magnetischen Kügelchen.

**13.** Magnetsensorvorrichtung (1000) nach Anspruch 1, wobei mindestens ein Teil der Magnetsensorvorrichtung (1000) als monolithische integrierte Schaltung ausgeführt ist.

**14.** Magnetsensorvorrichtung (1000) nach Anspruch 1, wobei die Verarbeitungsschaltung (1002) vorgesehen ist, um ein analoges Signal zu digitalisieren und um das digitalisierte Signal zurückzuleiten.

**15.** Verfahren zur Erfassung magnetischer Teilchen (15), wobei das Verfahren Folgendes umfasst:

Anregen einer ersten Magnetfeld-Erzeugungseinheit (12) zum Erzeugen eines ersten Magnetfelds;
Erfassen eines Signals durch eine Erfassungseinheit (11), wobei das Signal auf die Anwesenheit der magnetischen Teilchen (15) in dem ersten Magnetfeld hinweist;
Erzeugen eines zweiten Magnetfelds, das die Erfassungseinheit (11) beeinflusst, durch eine zweite Magnetfeld-Erzeugungseinheit (1001);
Verarbeiten des Signals zum Bilden eines digitalisierten Signals und Zurückleiten des verarbeiteten Signals an die zweite Magnetfeld-Erzeugungseinheit (1001).

**Revendications**

**1.** Dispositif de détecteur magnétique (1000) destiné à détecter des particules magnétiques (15), le dispositif de détecteur magnétique (1000) comprenant

une première unité de générateur de champ magnétique (12) susceptible d'être excitée afin de générer un premier champ magnétique ;
une unité de détection (11) adaptée pour détecter un signal indicatif de la présence des particules magnétiques (15) dans le premier champ magnétique ;
une deuxième unité de générateur de champ magnétique (1001) adaptée pour générer un deuxième champ magnétique affectant l'unité de détection (11) ;
un système de circuit de traitement (1002) adapté pour traiter le signal de façon à former un signal numérisé et adapté pour renvoyer le signal traité à la deuxième unité de générateur de champ magnétique (1001).

**2.** Dispositif de détecteur magnétique (1000) selon la revendication 1,
comprenant un modulateur de courant (1003) adapté pour exciter la première unité de générateur de champ magnétique (12).

**3.** Dispositif de détecteur magnétique (1000) selon la revendication 1,
comprenant un convertisseur analogique-numérique sigma-delta, dans lequel le système de circuit de traitement (1002) fait partie du convertisseur analogique-numérique sigma-delta.

**4.** Dispositif de détecteur magnétique (1000) selon la revendication 1,
dans lequel le système de circuit de traitement (1002) comprend un convertisseur analogique-numérique (1004) adapté pour convertir le signal, qui est un signal analogique, en un signal numérique.

**5.** Dispositif de détecteur magnétique (1000) selon la revendication 4,
dans lequel le système de circuit de traitement (1002) comprend un convertisseur numérique-analogique (1005) adapté pour convertir le signal numérique en un signal de rétroaction analogique destiné à être renvoyé vers la deuxième unité de générateur de champ magnétique (1001).

**6.** Dispositif de détecteur magnétique (1000) selon la revendication 4,
dans lequel le système de circuit de traitement (1002) comprend un filtre à boucle (1006), en particulier un filtre à boucle d'intégration, connecté entre l'unité de détection (11) et le convertisseur analogique-numérique (1004).

**7.** Dispositif de détecteur magnétique (1000) selon la revendication 1,
dans lequel la deuxième unité de générateur de champ magnétique (1001) est disposée pour maintenir les particules magnétiques (15) pratiquement sans influence.

8. Dispositif de détecteur magnétique (1100) selon la revendication 6,
dans lequel le système de circuit de traitement (1002) comprend un premier hacheur (1101) connecté entre l'unité de détection (11) et le filtre à boucle (1006).

9. Dispositif de détecteur magnétique (1000) selon la revendication 5,
dans lequel le système de circuit de traitement (1002) comprend un deuxième hacheur (1102) connecté entre le convertisseur analogique-numérique (1004) et le convertisseur numérique-analogique (1005).

10. Dispositif de détecteur magnétique (1000) selon la revendication 1,
dans lequel l'unité de détection (11) est adaptée pour détecter les particules magnétiques (15) sur base de l'effet magnétorésistif géant.

11. Dispositif de détecteur magnétique (1000) selon la revendication 1,
dans lequel l'unité de détection (11) est adaptée pour détecter quantitativement les particules magnétiques (15).

12. Dispositif de détecteur magnétique (1000) selon la revendication 1,
adapté pour détecter des perles magnétiques fixées à des molécules biologiques.

13. Dispositif de détecteur magnétique (1000) selon la revendication 1,
dans lequel au moins une partie du dispositif de détecteur magnétique (1000) est réalisée en tant que circuit intégré de façon monolithique.

14. Dispositif de détecteur magnétique (1000) selon la revendication 1,
dans lequel le système de circuit de traitement (1002) est adapté pour numériser un signal analogique et pour renvoyer le signal numérisé.

15. Procédé de détection de particules magnétiques (15), le procédé comprenant

l'excitation d'une première unité de générateur de champ magnétique (12) afin de générer un premier champ magnétique ;
la détection, par une unité de détection (11), d'un signal indicatif de la présence des particules magnétiques (15) dans le premier champ magnétique ;
la production, par une deuxième unité de générateur de champ magnétique (1001), d'un deuxième champ magnétique affectant l'unité de détection (11) ;
le traitement du signal de façon à former un signal numérisé et le renvoi du signal traité vers la deuxième unité de générateur de champ magnétique (1001).

FIG. 1

FIG. 2

400

625

620 — 402

615

610

605

R [ohm]

600

595

403

590

585

-40000          -20000          0          20000

H [A/m]          401

## FIG. 3

500

Vdd

501

f₁

502

uGMR

503
A

H(t)

RGMR

12

15

11

1009          1009

## FIG. 4

FIG. 5

FIG. 6

FIG. 7

FIG. 8

FIG. 9

FIG. 10

FIG. 11

FIG. 12

FIG. 13

FIG. 14

EP 2 109 771 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1469311 A1
- WO 2005010542 A
- US 20040033627 A
- WO 2006042839 A
- WO 2006059268 A
- WO 2005010543 A